# EUROPEAN PATENT APPLICATION

(11) **EP 1 635 384 A1**
(43) Date of publication of application: **15.03.2006**
(21) Application number: 04021594.9
(22) Date of filing: 10.09.2004
(51) Int. Cl.: H01L 21/306, H01L 29/861, H01L 21/00

(54) **Method for manufacturing power diode and equipment for the same**

(71) Applicant: Actron Technology Corporation, Taoyuan, Taiwan (TW)
(72) Inventor: Sheen, Charng-Geng, Taoyuan, Taiwan (TW)
(74) Representative: Viering, Hans-Martin

(57) **Abstract**

A method and equipment for manufacturing a power diode are described. More particularly, a manufacturing method and a unit of equipment used to remove an exposed portion of a P-N junction of a semiconductor (especially for power diodes) are described. The equipment has a reaction vessel having an input outlet and defining an airtight space inside. The power diode is placed inside the reaction vessel. A plasma generator is used to ionize an etching gas to produce free radicals and ions. The plasma generator is connected with the input outlet to flush the ionized etching gas into the reaction vessel. A shield plate is disposed under the input outlet of the reaction vessel to form a flow direction and a concentration distribution of the etching gas to etch a laterally exposed portion of the P-N junction.

## Description

### BACKGROUND OF THE INVENTION

### 1. Field of the Invention

The present invention is directed to a method and equipment for manufacturing a power diode, and more particularly, to a manufacturing method and equipment used to remove an exposed portion of a P-N junction of a semiconductor (especially for power diode).

### 2. Description of Related Art

In general, a conventional power diode has three parts, including a cold base, a diode chip and a top wire. These three parts will be soldered together. After soldering process, it is necessary to remove the laterally exposed portion of the P-N junction of the semiconductor to increase the blocking ability of the P-N junction.

In the conventional manufacture method, the laterally exposed portion of the P-N junction is usually removed by using an alkaline solution, such as KOH solution, to perform an etching process. However, using this method will cause different etching results for semiconductors with different impurity concentrations.

Furthermore, in the etching process using the alkaline solution, different etching systems require etching solutions having different concentrations, temperatures or potential differences defined in electrochemistry. In addition, since the liquid etching method includes many necessary processing steps, its complexity is very high.

In the conventional manufacture method of power diode, since a lot of factors and steps must be considered and performed, the products usually have defects caused by improper handling.

Accordingly, as discussed above, the prior art still has some drawbacks that could be improved. The present invention aims to resolve the drawbacks in the prior art.

### SUMMARY OF THE INVENTION

An objective of the present invention is to provide a method and equipment for manufacturing a power diode that use an etching gas to remove the laterally exposed portion of the P-N junction of the semiconductor chip.

Another objective of the present invention is to provide a method and equipment for manufacturing a power diode that use a shield plate to improve the concentration distribution of the etching gas inside the reaction vessel, prevent the unnecessary flow directions of the gas.

Still another objective of the present invention is to provide a method and equipment that can simplify the etching process and architecture for manufacturing a power diode. Thereby, the cost can be lowered and the quality of the products can be improved.

For reaching the objectives above, the present invention provides a method and equipment for manufacturing the power diode. The equipment includes a reaction vessel having an input outlet and defining an airtight space inside, into which reaction vessel the power diode is placed; a plasma generator used to ionize an etching gas to produce free radicals and ions, in which the plasma generator is connected with the input outlet to flush the radicals into the reaction vessel; and a shield plate disposed under the input outlet of the reaction vessel to form a flow direction and a concentration distribution of the radicals to etch a laterally exposed portion of the P-N junction.

Numerous additional features, benefits and details of the present invention are described in the detailed description, which follows.

### BRIEF DESCRIPTION OF THE DRAWINGS

The foregoing aspects and many of the attendant advantages of this invention will be more readily appreciated as the same becomes better understood by reference to the following detailed description, when taken in conjunction with the accompanying drawings, wherein:
Fig. 1 is a schematic diagram of a unit of manufacturing equipment in accordance with present invention; and
Figs. 2A-2B are detailed schematic diagrams of the diode chip in accordance with the present invention.

### DETAILED DESCRIPTION OF PREFERRED EMBODIMENTS

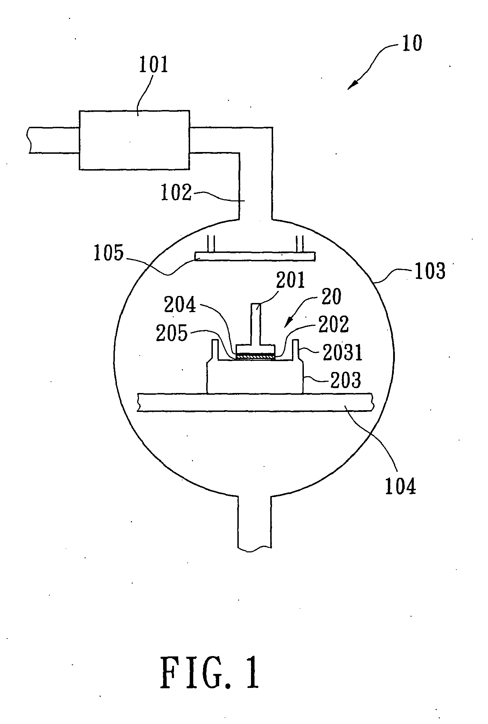

Reference is made to Fig. 1. The present invention provides a unit manufacturing equipment 10 to produce a power diode. Manufacturing equipment 10 includes a plasma generator 101, a pipe 102, a reaction vessel 103, a carrier 104 and a shield plate 105. The shield plate 105 is disposed directly under the outlet of the pipe 102 to control the flow direction of the input gas. The carrier 104 is used to carry a power diode 20. The manufacturing equipment 10 can perform a removal process on the power diode 20, i.e., the method of the present invention.

The power diode 20 has three main parts, including a top wire 201, a diode chip 202, and a cold base 203. Solder layers 204, 205 are used to integrate these three parts together. In addition, the cold base 203 has a protection plate 2031 surrounding the diode chip 202.

In the beginning of method according to the present invention, the manufacturing equipment 10 will provide a fluoride gas to the plasma generator 101. The fluoride gas is used for etching and is, for example, NF₃, SF₆, CF₄. The plasma generator 101 may mix the fluoride gas with an oxygen gas, such as, for example, O₂, N₂O, to increase the etching efficiency and decrease the deposition of the etching gas. However, the present invention is not limited to addition of oxygen gas.

When the manufacturing equipment 10 provides the fluoride gas to the plasma generator 101, the plasma generator 101 will generate a high-frequency electromagnetic wave to ionize this etching gas to produce the plasma having ions and free radicals. These free radicals will react with the laterally exposed portion of the P-N junction of the diode chip 202 chemically so as to remove the laterally exposed portion.

After the plasma generator 101 ionizes the etching gas, it will flush the etching gas into the reaction vessel 103 via the pipe 102. The etching gas will be flushed onto the shield plate 105 first. The shield plate 105 can effectively improve the distribution of the etching gas inside the reaction vessel 103 so as to prevent the unnecessary flow directions of the gas.

After the etching gas passes over the shield plate 105, it will convolute inside the reaction vessel 103 and react with the laterally exposed portion of the P-N junction of the diode chip 202 chemically so as to remove the laterally exposed portion by etching. Finally, after the reaction is finished, the etching gas will be drained out from the outlet at the bottom of the reaction vessel 103.

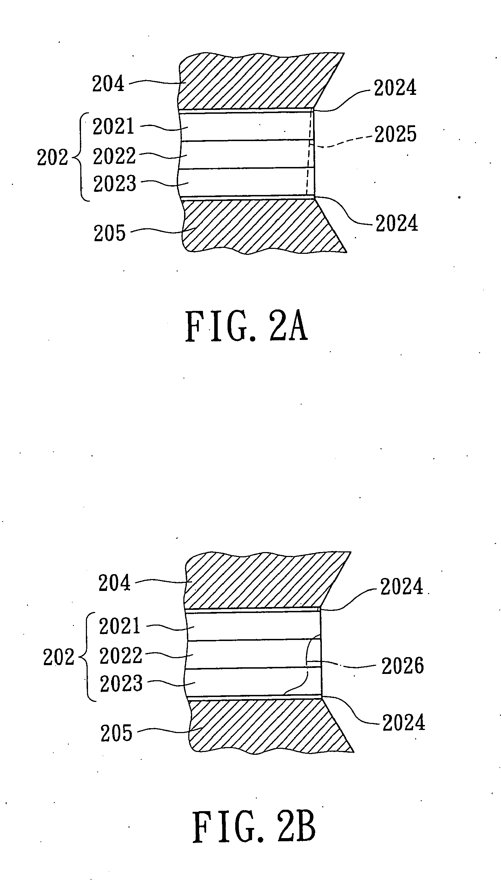

Reference is made to Fig. 2A, which is a detailed schematic diagram of the diode chip 202. Diode chip 202 includes three semiconductor layers. In this embodiment, diode chip 202 includes a p⁺ layer 2021, an n layer 2022 and an n⁺ layer 2023. The impurity inside the p⁺ layer 2021 is boron and the impurity inside the n layer 2022 and n⁺ layer 2023 is phosphorus. However, the present invention is not limited to these impurities.

Moreover, in practice, both of the upper and lower layers of the diode chip 202 usually have a nickel layer 2024 to make the diode chip 202 easier to solder to the top wire 201 and the cold base 203. Further reference is made to Figs. 2A and 2B; the dotted line 2025 shown in Fig. 2A is an etching line of the present invention and the dotted line 2026 shown in Fig. 2B is an etching line of the prior art using liquid solution.

Obviously, the etching line of the present invention is flatter and hence can make the power diode made by the present invention have better electrical properties. In addition, when compared with the method using a liquid etching solution, the method using the etching gas is simpler and can be controlled more easily. Hence, the method and equipment for manufacturing power diode according to the present invention can improve the quality of the products.

Moreover, since the present invention uses the shield plate 105 to improve the distribution of the etching gas inside the reaction vessel 103, thus preventing the unnecessary flow directions of the plasma, the present invention can have high etching efficiency and obtain the expected etching surface, even for the power diode 20 surrounded by the protection plate 2031.

It should be noted, via using the shield plate 105, the present 'invention needn't use an additional heating device to increase the etching efficiency. Additionally, due to the shield plate 105, the present invention doesn't need additional through holes in the carrier 104 to assist the flowing of the plasma. The present invention equipped with the carrier 104, which has no through holes or only has gas holes on the side, can still have effective etching results. Hence, the present invention has a simpler structure and a lower cost.

Although the present invention has been described with reference to the preferred embodiment thereof, it will be understood that the invention is not limited to the details thereof. Various substitutions and modifications have been suggested in the foregoing description, and other will occur to those of ordinary skill in the art. Therefore, all such substitutions and modifications are embraced within the scope of the invention as defined in the appended claims.

## Claims

1. A method for manufacturing a power diode, the power diode having a diode chip and a P-N junction exposed laterally, the method comprising:
placing the power diode in a reaction vessel having a shield plate;
providing an etching gas;
ionizing the etching gas to produce free radicals and ions; and
flushing the radicals over to the shield plate to form a flow direction and a concentration distribution of the etching gas to etch a laterally exposed portion of the P-N junction.

2. The method as claimed in claim 1, wherein the step of ionizing the etching gas includes:
using a plasma generator to generate a high-frequency electromagnetic wave to ionize the etching gas.

3. The method as claimed in claim 1, wherein the step of ionizing the etching gas includes:
using a plasma generator to mix the etching gas with an oxygen gas.

4. The method as claimed in claim 3, wherein the oxygen gas is O₂ or N₂O.

5. The method as claimed in claim 1, wherein the etching gas is NF₃, SF₆ or CF₄.

6. An equipment for manufacturing a power diode, the power diode having a diode chip and a P-N junction exposed laterally, the equipment comprising:
a reaction vessel having an input outlet and defining an airtight space inside, the power diode being placed inside the reaction vessel;
a plasma generator used to ionize an etching gas to produce free radicals and ions, the plasma generator being connected with the input outlet to flush the ionized etching gas into the reaction vessel; and
a shield plate disposed under the input outlet of the reaction vessel to form a flow direction and a concentration distribution of the etching gas to etch a laterally exposed portion of the P-N junction.

7. The equipment as claimed in claim 6, wherein the plasma generator mixes the etching gas with an oxygen gas.

8. The equipment as claimed in claim 7, wherein the oxygen gas is O₂ or N₂O.

9. The equipment as claimed in claim 6, wherein the etching gas is NF₃, SF₆ or CF₄.

10. The equipment as claimed in claim 6, wherein the reaction vessel further includes a carrier to hold the power diode.

11. The equipment as claimed in claim 6, further comprising a pipe used to connect the plasma generator with the input outlet of the reaction vessel.

12. The equipment as claimed in claim 6, wherein the reaction vessel further includes an output outlet used to drain out the etching gas.
